Europäisches Patentamt

European Patent Office

Office européen des brevets

(19)

(11) Veröffentlichungsnummer: **0 007 677**
**B1**

(12) # EUROPÄISCHE PATENTSCHRIFT

(45) Veröffentlichungstag der Patentschrift:
24.03.82

(51) Int. Cl.³: **H 04 M 15/04,** H 04 Q 3/42,
H 04 Q 3/00, G 01 R 19/165

(21) Anmeldenummer: 79200414.5

(22) Anmeldetag: 23.07.79

(54) Schaltungsanordnung zur Ueberwachung des Verlaufs der Potentiale auf mehreren Leitungen.

(30) Priorität: 24.07.78 CH 7954/78

(43) Veröffentlichungstag der Anmeldung:
06.02.80 Patentblatt 80/3

(45) Bekanntmachung des Hinweises auf die Patenterteilung:
24.03.82 Patentblatt 82/12

(84) Benannte Vertragsstaaten:
AT CH DE FR GB IT NL SE

(56) Entgegenhaltungen:
US-A-2 691 729
US-A-3 810 012
US-A-3 821 484
US-A-3 925 623
US-A-3 936 611
US-A-3 989 959

IEEE TRANSACTIONS ON COMMUNICATIONS,
Vol. COM-23, Nr. 7,
Juli 1975,
New York, US,
J. C. McDONALD: «A new electronic telephone accounting system for local telephone calls»,
Seiten 705-714

(73) Patentinhaber: Autophon A.G., Ziegelmattstrasse 1-15,
CH-4500 Solothurn 3 (CH)

(72) Erfinder: Waber, Urs, Buchenstrasse 19,
CH-4500 Solothurn (CH)
Erfinder: Herrmann, Ueli, Grederstrasse 60,
CH-4512 Bellach (CH)
Erfinder: Aeberhard, Martin, Tannenweg 27,
CH-4500 Solothurn (CH)

(74) Vertreter: Bovard, Fritz Albert et al, Bovard & Cie.
Patentanwälte VSP-Rechtsanwälte Optingenstrasse 16,
CH-3000 Bern 25 (CH)

Schaltungsanordnung zur Überwachung des Verlaufs der Potentiale auf mehreren Leitungen

Die vorliegende Erfindung betrifft eine für den Anschluss an eine Telefonzentrale bestimmte Schaltungsanordnung zur Überwachung des Verlaufs der Potentiale auf mehreren Leitungen bzw. der Potentialdifferenzen auf mehreren Leitungspaaren in bezug auf das Über- oder Unterschreiten eines einzigen bestimmten Schwellenwertes durch die einzelnen Potentiale bzw. Potentialdifferenzen. In dieser Anordnung werden mit Hilfe mindestens eines Komparators und eines festen Vergleichspotentials in Abhängigkeit von den überwachten Potentialen Binärwerte erzeugt, und auf dem Weg zwischen den Leitungen und einem Ausgang für die genannten Binärwerte ist ein in zyklischer Folge mit den einzelnen Leitungen in Beziehung tretender Multiplexer angeordnet.

Eine solche Schaltungsanordnung ist beispielsweise in der amerikanischen Patentschrift 3 925 623 beschrieben. Das Über- oder Unterschreiten eines einzigen bestimmten Schwellenwertes wird dort je in einem jeder Leitung fest zugeordneten Stromkreis festgestellt, und die binären Ausgänge dieser Stromkreise werden mit einem Binär-Multiplexer nach einem Hauptausgang zyklisch durchgeschaltet, von wo sie einer zentralen Auswerteanordnung zugeleitet werden.

In bestimmten Fällen ergibt sich beim Aufzeichnen von Gesprächsdaten das Bedürfnis, das Über- und Unterschreiten von mehr als einem Schwellenwert durch die verschiedenen Potentiale bzw. Potentialdifferenzen festzustellen. Würde in einem solchen Falle die aus der amerikanischen Patentschrift 3 925 623 bekannte Technik angewandt, würde dies zu einem sehr hohen Aufwand führen. Aus dem Artikel von John C. Mc Donald: «A New Electronic Telephone Accounting System for Local Calls», erschienen in IEEE Transactions on Communications, Vol. COM-23 (1975), Nummer 5, Seiten 705 ... 714, ist eine Einrichtung bekannt geworden, in welcher drei Schwellenwerte unterschieden werden und in welcher das Über- oder Unterschreiten von Schwellenwerten nicht durch den einzelnen Leitungen zugeordnete Stromkreise, sondern durch drei zentrale Prüfeinrichtungen geprüft wird, denen die Leitungspotentiale über einen Analog-Multiplexer zugeführt werden.

Ein nicht für die Abtastung von Telefonleitungen bestimmtes Prüfgerät mit zyklischer Abtastung durch einen Analog-Multiplexer ist ferner in der amerikanischen Patentschrift 3 810 012 beschrieben. In diesem Prüfgerät werden verschiedene zu prüfende Spannungen zyklisch an einen Spannungsteiler mit einem digital veränderbaren Teilungsverhältnis angelegt. Die geteilte Spannung wird einem Komparator zugeführt, welcher an seinem Ausgang ein binäres Kriterium für das Über- oder Unterschreiten eines bestimmten Schwellenwertes durch die geteilte Spannung erzeugt. Das Teilverhältnis des Spannungsteilers wird dabei nach einem Programm entsprechend den zu erwartenden Messwerten synchron mit dem Multiplexer eingestellt.

Ein weiteres Beispiel einer Einrichtung zur Feststellung des Über- oder Unterschreitens eines Schwellenwertes ist in der amerikanischen Patentschrift 3 989 959 beschrieben. Dort wird ein Eingangssignal zwei Operationsverstärkern zugeführt, deren Ausgänge je mit einem Eingang eines Komparators verbunden sind. Je für das Über- und Unterschreiten eines bestimmten positiven und eines bestimmten negativen Schwellenwertes durch das Eingangssignal werden von den Komparatoren entsprechende binäre Signale abgegeben. Die Schwellenwerte sind dabei in dieser in erster Linie für Herzschrittmacher bestimmten Schaltungsanordnung auf analoge Weise einstellbar.

Für Schaltungsanordnungen, in welchen eine grosse Zahl von Potentialen nur in bezug auf einen einzigen Schwellenwert geprüft werden müssen, ist eine Anordnung mit jeder Leitung einzeln zugeordneten Prüfmitteln, wie sie in der zuerst zitierten amerikanischen Patentschrift 3 925 623 beschrieben ist, an sich die nächstliegende und einfachste Lösung. Der Schwellenwert und die Art der Zuordnung der Ausgangssignale zum Über- oder Unterschreiten des Schwellenwertes sind dabei durch den Aufbau der Schaltung festgelegt. Es hat sich nun aber gezeigt, dass bei verschiedenen Typen von Telefonzentralen einerseits der für die Auswertung in Frage kommende Schwellenwert in bezug auf absoluten Betrag und Polarität verschieden ist und andererseits die binären Werte der dem Über- bzw. Unterschreiten des Schwellenwertes jeweils zuzuordnenden Ausgangssignale voneinander abweichen. Lagerhaltung und Ersatzbeschaffung solcher Schaltungsanordnungen mit festgelegten Werten sind daher erschwert.

Die vorliegende Erfindung ermöglicht nun die Schaffung einer Schaltungsanordnung, bei welcher der Schwellenwert, die Polarität des Schwellenwertes und der dem Über- bzw. Unterschreiten des Schwellenwertes zugeordnete Ausgangs-Binärwert sehr leicht eingestellt werden können, welche daher an verschiedene Typen von Telefonzentralen anschaltbar ist und bezüglich Lagerhaltung und Ersatzbeschaffung grosse Vorteile bietet.

Die vorliegende Erfindung betrifft nun eine Schaltungsanordnung der eingangs beschriebenen Art, welche Schaltungsanordnung durch die im kennzeichnenden Teil des Patentanspruches 1 aufgeführten Merkmale gekennzeichnet ist.

Besondere Ausführungsformen der Erfindung betreffen Anordnungen, in welchen die Potentiale vorerst in Ströme umgewandelt und in der Form von Strömen über den Analog-Multiplexer geleitet werden. Eine weitere besondere Ausführungsform betrifft eine Anordnung, in welcher die Polarität des Ausgangssignals in sehr einfacher Weise invertiert werden kann.

Die Erfindung wird nun anhand von zwei Ausführungsbeispielen erklärt.

Die Fig. 1 zeigt das Schema einer Schaltungsanordnung zur Überwachung einzelner Leitungen und

die Fig. 2 zeigt das Schema einer Schaltungsanordnung zur Überwachung von Leitungspaaren.

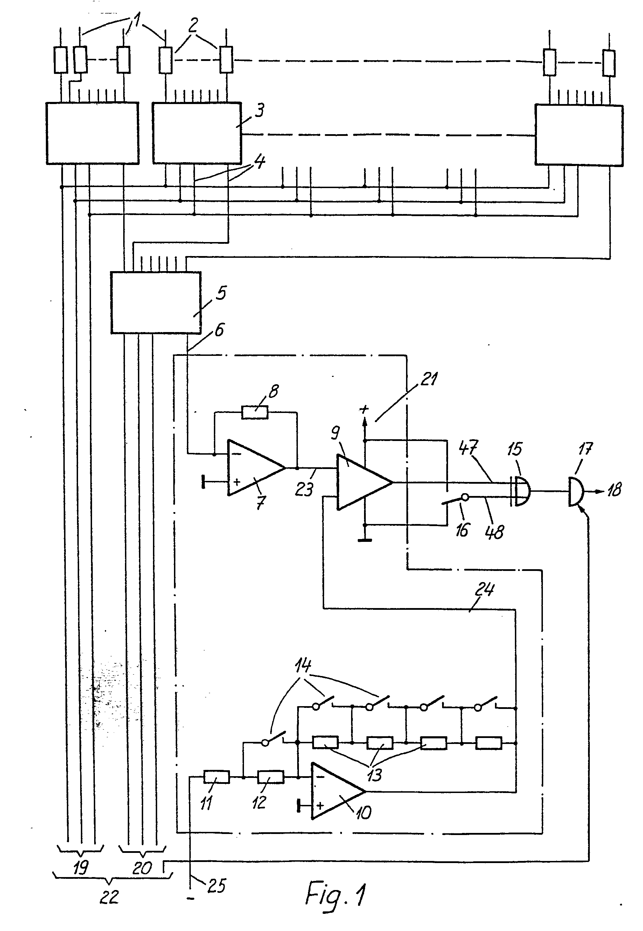

Die in Fig. 1 dargestellte Schaltungsanordnung dient der Erfassung von auf 64 Leitungen 1 in beliebiger Folge einlaufenden Gebührenimpulsen. Je 8 solcher Leitungen 1 sind über je einen hochohmigen Widerstand 2 von beispielsweise 1 MΩ an einen Analog-Multiplexer 3, z.B. vom Typ CD 4051B, angeschlossen. Die Ausgänge 4 dieser 8 Multiplexer sind mit den 8 Eingängen des Analog-Multiplexers 5 verbunden, dessen Ausgang 6 mit dem Eingang der Prüfeinrichtung 21 verbunden ist. Diese Prüfeinrichtung enthält einen Operationsverstärker 7, von dem ein erster Eingang mit dem Eingang der Prüfeinrichtung 21 verbunden ist, ein zweiter Eingang am Nullpotential liegt und dessen Ausgang 23 über einem Widerstand 8 mit dem ersten Eingang verbunden ist. Bekanntlich weist ein solcher Operationsverstärker einen sehr hochohmigen Eingang und eine sehr grosse Verstärkung auf. Die Polarität des Ausgangspotentials ist dabei derjenigen des (sehr kleinen) Potentials am ersten Eingang entgegengesetzt. Praktisch ist das Potential auch am ersten Eingang null. Infolge der Wirkung des Widerstandes 8 zwischen Ausgang 23 und Eingang 6 stellt sich ein Gleichgewicht ein, wenn der dem Eingang zugeführte Strom dem Strom im Widerstand 8 entspricht. Das seinerseits den Strom im Widerstand 8 verursachende Potential am Ausgang 23 des Verstärkers ist somit dem Strom Eingang proportional.

Ein weiterer Operationsverstärker 10 erzeugt ein Bezugspotential, welches zum Speisepotential in einem bestimmten Verhältnis steht. Ein erster Eingang dieses Operationsverstärkers ist über die Widerstände 11 und 12 an den negativen Pol der die ganze Schaltungsanordnung speisenden Spannungsquelle angeschlossen, während der zweite Eingang an Nullpotential gelegt ist. Eine Reihe von in ihrem Wert binär abgestuften Widerständen 13 liegt zwischen seinem ersten Eingang und seinem Ausgang 24. Der Widerstand 12 und die Widerstände 13 können durch örtlich betätigte Schalter 14 kurzgeschlossen werden. Wie sich aus den vorherigen Ausführungen zum Verhalten der Operationsverstärker ergibt und allgemein bekannt sein dürfte, steht bei einem derart geschalteten Verstärker das Ausgangspotential in einem durch die einerseits zwischen Speisepotential und erstem Eingang und andererseits zwischen Ausgang und erstem Eingang vorhandenen Widerstände gegebenen Verhältnis zum Speisepotential. Durch wahlweises Schliessen und Öffnen der Schalter 14 kann somit das Ausgangspotential 24 des Verstärkers 10 in kleinen, genau definierten Stufen verändert werden.

Einem Komparator 9 werden an seinen beiden Eingängen die Ausgangspotentiale 23 und 24 der Operationsverstärker 7 und 10 zugeführt. Der Komparator wird durch ein positives Potential und das Nullpotential gespeist und erzeugt an seinem Ausgang ein Binärsignal, dessen Wert von der Polarität der zwischen seinen beiden Eingängen angelegten Spannung abhängt. Das Potential dieses Binärsignals entspricht jeweils einem der beiden Speisepotentiale.

Das Ausgangssignal 47 des Komparators 9 ist an einen Eingang eines EXKLUSIV-ODER-Tors 15 angelegt, an dessen andern Eingang durch den Schalter 16 wahlweise eines der beiden Speisepotentiale des Komparators als Steuersignal 48 angelegt werden kann. Es ist nun leicht einzusehen, dass der Binärwert am Ausgang des Komparators 9 in der einen Stellung des Schalters 16 unverändert über das Tor 15 übertragen wird, während er in der andern Stellung des Schalters invertiert wird. Der Ausgang des Tors 15 führt über einen elektronischen Schalter 17 (Tristate Buffer) an den Ausgang 18.

Eine nicht dargestellte, bei 22 angeschlossene Steuereinrichtung steuert nun über die 3 Leitungen 19 alle Multiplexer 3 derart, dass je die Eingänge 1 der Reihe nach auf den Ausgang 4 durchgeschaltet werden. Von derselben Steuereinrichtung wird über die Leitungen 20 der Multiplexer 5 derart gesteuert, dass er der Reihe nach die Ausgänge 4 der Multiplexer 3 mit seinem Ausgang 6 verbindet. Die Takte auf den Leitungen 19 und 20 sind derart aufeinander abgestimmt, dass jeder der Eingänge 4 während eines an den Eingängen der Multiplexer 3 ablaufenden Abtastzyklus durchgeschaltet ist. Auf diese Weise werden zyklisch sämtliche Leitungen 1 für den Durchgang von Analogsignalen nach dem Ausgang 6 durchgeschaltet.

Wie früher bereits erklärt wurde, hat der Operationsverstärker 7 in der angegebenen Schaltung die Eigenschaft, dass das an seinem Ausgang entstehende Potential proportional zum Strom ist, welcher über den Eingang 6 fliesst. Da die Durchgangswiderstände der Multiplexer gegenüber dem betreffenden hochohmigen Widerstand 2 vernachlässigt werden können, ist dieser Strom allein durch das Potential an der durchgeschalteten Leitung 1 und den zugehörigen Widerstand 2 bestimmt und somit proportional dem Potential an dieser Leitung. Sofern sämtliche Widerstände 2 gleich hoch vorausgesetzt werden, ist somit das Potential am Ausgang 23 des Operationsverstärkers 7 für das Potential an der durchgeschalteten Leitung 1 massgebend, und am Ausgang 47 des Komparators 9 und des Tors 15 erscheint somit ein Binärwert, welcher angibt, ob das Potential an der Leitung ober- oder unterhalb eines bestimmten Schwellenwertes ist, wobei dieser Schwellenwert von dem am Ausgang 24 des Verstärkers 10 auftretenden Bezugspotential abhängt.

Das Tor 17 wird jeweils durch die nicht dargestellte Steuereinrichtung während des durchgeschalteten Zustandes der Multiplexer in den leitenden Zustand versetzt und ist während der Umschaltung der Multiplexer gesperrt. Die am Ausgang 18 abgegebenen Signale werden auf nicht dargestellte und mit der Erfindung in keinem Zusammenhang stehende Weise weiter verarbeitet. Es ist möglich, die Ausgänge von mehreren der Fig. 1 entsprechenden und je 64 Eingänge aufweisenden Schaltungsanordnungen zusammenzuschalten und deren Eingänge nacheinander abzutasten, indem jeweils nur eines der Tore 17 in den leitenden Zustand versetzt wird. Es wäre auch möglich, eine weitere Stufe von Multiplexern einzuführen und so die beschriebene Schaltungsanordnung für die Überwachung einer 64 übersteigenden Zahl von Leitungen zu verwenden. Der Erzeuger des Vergleichspotentials könnte auch für mehrere Schaltungsanordnungen gemeinsam vorgesehen werden.

Sollten die im gesperrten Zustand der Multiplexer an den Leitungen auftretenden Potentiale den Wert übersteigen, der an den Multiplexern zugelassen werden kann, kann zwischen jedem Eingang der Multiplexer 3 und Nullpotential je ein nicht dargestellter Widerstand angeschlossen werden, welcher im gesperrten Zustand des betreffenden Eingangs zusammen mit dem betreffenden Widerstand 2 einen Spannungsteiler bildet und die am Multiplexer liegende Spannung vermindert. Auf den Strom in den durch die Multiplexer geschalteten Verbindungen und damit auf das am Eingang des Komparators gelieferte Potential haben diese zusätzlichen Widerstände keinerlei Einfluss.

Die beschriebene Schaltungsanordnung kann für die Überwachung von Leitungen dienen, deren Potential in bezug auf einen Schwellenwert beliebiger Höhe und Polarität zu prüfen ist, wobei der das Ergebnis dieser Prüfung bildende Binärwert in beliebiger Weise der Über- und der Unterschreitung des Schwellenwertes zugeordnet werden soll. Der Schwellenwert kann dabei in einfacher und wiederholbarer Weise an den Schaltern 14 und die genannte Zuordnung am Schalter 16 eingestellt werden. Dies ermöglicht eine preisgünstige Serienfertigung solcher Schaltungsanordnungen, bei denen lediglich die genannten Schalter in geeigneter Weise einzustellen sind, wenn sie unter vorgeschriebenen Bedingungen eingesetzt werden müssen.

Da der Schwellenwert nicht ein absoluter Wert ist sondern zum Potential der Speisespannung in einem festen Verhältnis steht, passt sich, sofern Speisespannungsschwankungen auftreten und damit die auf den Leitungen auftretenden Potentiale beeinflussen, der Schwellenwert diesen Schwankungen an.

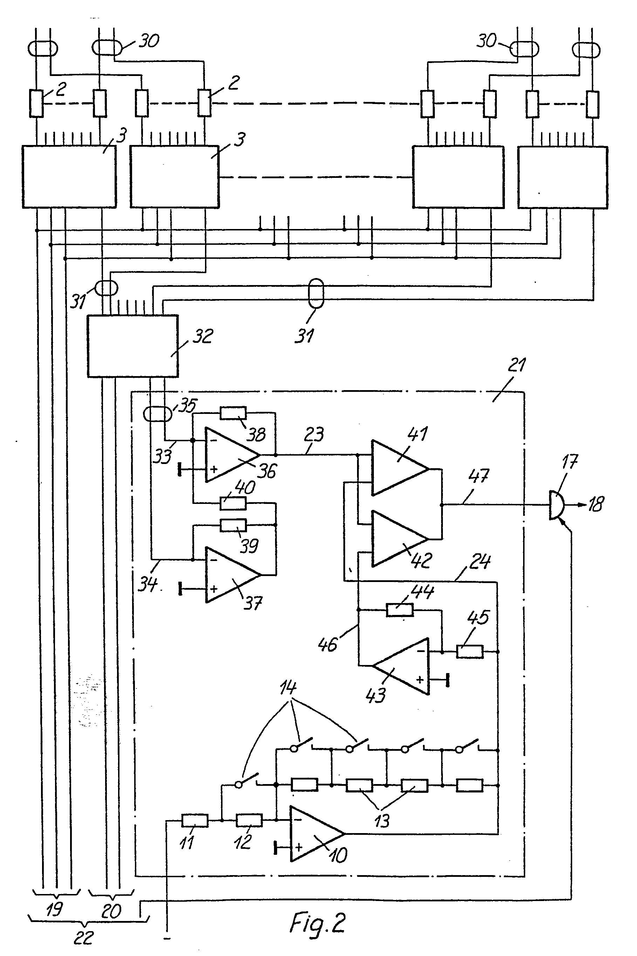

Die Schaltungsanordnung, deren Schema in Fig. 2 dargestellt ist, ist zur Überwachung der Potentialdifferenzen auf 32 Leitungspaaren bestimmt. Ein grosser Teil der darin verwendeten Einrichtungen entspricht den in bezug auf Fig. 1 beschriebenen, wobei in den genannten Fällen die gleichen Bezeichnungen gewählt wurden. Bei der Schaltungsanordnung gemäss Fig. 2 sind ebenfalls 8 Analog-Multiplexer 3 vorhanden, wobei jedoch, im Gegensatz zur Fig. 1, jeweils zwei einander zugeordnet sind und die zu überwachenden Leitungspaare 30 jeweils an die einander entsprechenden Anschlüsse eines Multiplexer-Paars angeschlossen sind. Je die beiden Ausgänge 31 dieser Multiplexer-Paare sind mit den Eingängen des Multiplexers 32 verbunden.

Es handelt sich dabei um einen Analog-Multiplexer mit 4 Paaren von Eingängen, welche er wahlweise nach dem aus den beiden Adern 33 und 34 bestehenden Ausgangspaar 35 durchschaltet. Die Ader 33 führt auf einen ersten Eingangs des Operationsverstärkers 36 und die Ader 34 auf einen ersten Eingang des Operationsverstärkers 37, während die zweiten Eingänge dieser Verstärker je auf Nullpotential liegen. Bei jedem dieser Verstärker ist in analoger Weise wie beim Verstärker 7 in Fig. 1 der eine Eingang durch einen Widerstand 38 bzw. 39 mit dem Ausgang verbunden, während ein weiterer Widerstand 40 zwischen dem Ausgang des Verstärkers 37 und dem ersten Eingang des Verstärkers 36 verläuft. Die Widerstände 38, 39 und 40 sind gleich hoch.

Der Widerstand 40 bewirkt, dass am Ausgang des Verstärkers 36 ein Potential auftritt, welches der Differenz der beiden in den Adern 33 und 34 fliessenden Ströme und damit auch der Potentialdifferenz des angeschalteten Leitungspaares 30 proportional ist. Um diese Differenzbildung zu erklären wird davon ausgegangen, dass das Potential am Ausgang des Verstärkers 37 dem Strom in der Verbindung 34 proportional ist. Aufgrund dieses Potentials fliesst im Widerstand 40 ein Strom, welcher ebenfalls dem Strom in der Verbindung 34 proportional ist. Der Strom im Widerstand 38 muss sich nun derart einstellen, dass er der Differenz der Ströme in der Verbindung 33 und im Widerstand 40 entspricht, was nur dann der Fall ist, wenn das Potential am Ausgang des Verstärkers 36 ebenfalls der Differenz der Ströme im Leitungspaar 35 entspricht. Das am Ausgang 23 des Verstärkers 36 entstehende Potential, dessen Polarität beliebig sein kann, wird nun parallel je den ersten Eingängen der Komparatoren 41 und 42 zugeführt. Der zweite Eingang des Komparators 41 ist, entsprechend dem Komparator 9 in Fig. 1, mit dem vom Verstärker 10 abgegebenen Vergleichspotential 24 verbunden, während an den zweiten Eingang des Komparators 42 das inverse Vergleichspotential 46 angelegt ist, welches durch den Operationsverstärker 43, dessen Parallelwiderstand 44 und Vorwiderstand 45 gleich hoch sind, aus dem Vergleichspotential 24 erzeugt ist.

Die Verhältnisse bei der Zusammenschaltung der Ausgänge der beiden Komparatoren 41 und 42 sind nun derart gewählt, dass, ausgehend vom Zustand, bei dem am Ausgang des Verstärkers 36 Nullpotential vorhanden ist, der Binärwert am Eingang 47 des Tors 17 ändert, wenn die Spannung zwischen den Eingängen an einem der Komparatoren ihre Richtung umkehrt. Unter diesen Voraussetzungen ändert somit der genannte Binärwert, wenn das Potential am Ausgang 23 des Verstärkers 36 einen positiven Vergleichswert über- oder einen negativen Vergleichswert unterschreitet, wobei der absolute Betrag der beiden Vergleichswerte gleich gross ist. Anders ausgedrückt bedeutet dies, dass der genannte Binärwert ausschliesslich von Vergleich des absoluten Betrags der auf dem überprüften Leitungspaar vorhandenen Potentialdifferenz mit dem Vergleichspotential abhängt. Die Weiterverarbeitung des binären Signals entspricht der in Fig. 1 dargestellten Anordnung. Auf diese Weise ist die einwandfreie Feststellung der Potentialdifferenz ohne Anwendung einer galvanischen Trennung auch dann möglich, wenn die Potentiale der zu überwachenden Leitungen und diejenigen der Schaltungsanordnung zu deren Überwachung nicht die gleiche Basis haben.

In den Ausführungsbeispielen sind jeweils die zweiten Eingänge der Operationsverstärker an Nullpotential gelegt, wodurch sich der Eingang der zentralen Prüfeinrichtung ebenfalls auf diesem Potential befindet. Grundsätzlich könnte aber auch ein anderes in bezug auf die zu überwachenden Potentiale feststehendes Potential verwendet werden.

## Patentansprüche

1. Für den Anschluss an eine Telefonzentrale bestimmte Schaltungsanordnung zur Überwachung des Verlaufs der Potentiale auf mehreren Leitungen (1) bzw. der Potentialdifferenzen auf mehreren Leitungspaaren (30) in bezug auf das Über- oder Unterschreiten eines einzigen bestimmten Schwellenwertes durch die einzelnen Potentiale bzw. Potentialdifferenzen, in welcher Anordnung sowohl mit Hilfe mindestens eines Komparators (9; 41, 42) und eines festen Vergleichspotentials (24) in Abhängigkeit von den überwachten Potentialen Binärwerte erzeugt werden als auch ein in zyklischer Folge mit den einzelnen Leitungen (1; 30) in Beziehung tretender Multiplexer (3, 5; 3, 32) auf dem Weg zwischen den Leitungen und einem Ausgang (18) für die genannten Binärwerte angeordnet ist, dadurch gekennzeichnet, dass der (die) Komparator(en) (9; 41, 42) in einer einzigen, zwischen dem Multiplexer (3, 5; 3, 32) und dem Ausgang (18) angeordneten zentralen Prüfeinrichtung (21) enthalten ist (sind), dass sie Prüfeinrichtung (21) einen dem Potential bzw. der Potentialdifferenz der über den Multiplexer (3, 5; 3, 32) daran angeschalteten Leitung (1) bzw.

des Leitungspaares (30) proportionales Messpotential (23) erzeugenden Operationsverstärker (7; 36, 37) enthält, dass der Multiplexer (3; 3, 32) ein Analog-Multiplexer ist und dass in kleinen und grossen Schritten digital einstellbare Schaltungsmittel (10, 11, 12, 13, 14) vorhanden sind, welche das Vergleichspotential (24) als ein zu einem Speisepotential (−) in einem bestimmten, fest eingestellten Verhältnis stehendes Potential erzeugen, wobei das Vergleichspotential (24) in Anpassung an verschiedene Typen von Telefonzentralen vor dem Einbau einmal fest eingestellt wird.

2. Schaltungsanordnung nach dem Patentanspruch 1, dadurch gekennzeichnet, dass jeder der genannten Leitungen (1) ein hochohmiger Widerstand (2) zugeordnet ist, welcher bei der Durchschaltung der betreffenden Leitung (1) zwischen Leitung und Eingang (6) des Operationsverstärkers (7) wirksam ist und dass der Verstärker (7) in einer Weise geschaltet ist, gemäss welcher sein Eingang (6), unabhängig vom Eingangsstrom, praktisch auf Nullpotential liegt und das an seinem Ausgang erscheinende Mess-Potential (23) proportional zu dem an seinem Eingang (6) fliessenden Strom ist.

3. Schaltungsanordnung nach dem Patentanspruch 1 für die Überwachung der Potentialdifferenz auf Leitungspaaren (30), dadurch gekennzeichnet, dass jeder Ader der genannten Leitungspaare je ein hochohmiger Widerstand (2) zugeordnet ist, welcher bei der Durchschaltung eines Paares zwischen der betreffenden Ader und dem Eingang (33, 34) eines der beiden Operationsverstärker (36, 37) wirksam ist und dass die Verstärker (36, 37) in einer Weise zusammengeschaltet sind, gemäss welcher ihre Eingänge (33, 34), unabhängig von den Eingangsströmen, praktisch auf Nullpotential liegen und das an einem gemeinsamen Ausgang (23) erscheinende Mess-Potential proportional zur Differenz der an ihren Eingängen (33, 34) fliessenden Ströme ist.

4. Schaltungsanordnung nach Patentanspruch 3, gekennzeichnet durch einen invertierenden Verstärker (43, 44, 45), welcher ein zum Vergleichspotential (24) inverses Potential (46) erzeugt, durch einen ersten Komparator (41) zum Vergleichen des genannten Mess-Potentials (23) mit dem Vergleichspotential (24) und durch einen zweiten Komparator (42) zum Vergleichen des Mess-Potentials (23) mit dem invertierten Vergleichspotential (46), wobei die Ausgänge (47) der beiden Komparatoren derart parallel an den Ausgang der Prüfeinrichtung geschaltet sind, dass das Ausgangssignal (18) der Prüfeinrichtung ausschliesslich vom Vergleich des absoluten Betrages der Potentialdifferenz mit dem Schwellenwert abhängt.

5. Schaltungsanordnung nach dem Patentanspruch 1, gekennzeichnet durch ein EXKLUSIV-ODER-Tor (15) mit zwei Eingängen, an dessen einen Eingang der Ausgang der Prüfeinrichtung (47) und an dessen andern Eingang ein Steuersignal (48) angeschlossen ist, mit dessen Hilfe das digitale Ausgangssignal der Prüfeinrichtung wahlweise invertierbar ist.

## Claims

1. Circuit arrangement intended to be connected to a telephone exchange for monitoring the variation of the potentials on a plurality of lines (1) or of the potential differences on a plurality of pairs (30) of lines with respect to the exceeding of or falling below a single specific threshold value by the individual potentials or potential differences, in which arrangement both binary values are produced with the aid of at least one comparator (9; 41, 42) and of a fixed reference potential (24) as a function of the monitored potentials, and also a multiplexer (3, 5; 3, 32), which enters into relationship with the individual lines (1; 30) in cyclic sequence, is disposed on the path between the lines and an output (18) for the said binary values, characterized in that the comparator(s) (9; 41, 42) is(are) contained in a single central test apparatus (21) disposed between the multiplexer (3, 5; 3, 32) and the output (18), that the test apparatus (21) contains an operational amplifier (7; 36, 37) producing a measuring potential (23) proportional to the potential or the potential difference of the line (1) or the pair (30) of lines connected thereto via the multiplexer (3, 5; 3, 32), that the multiplexer (3; 3, 32) is an analog multiplexer, and that there are circuit means (10, 11, 12, 13, 14) present which are digitally adjustable in large and small steps and which produce the reference potential (24) as a potential bearing a specific, permanently adjusted relationship to a supply potential (−), the reference potential (24) being permanently adjusted in conformity with various types of telephone exchanges sometime prior to installation.

2. Circuit arrangement according to claim 1, characterized in that with each of the said lines (1) there is associated a high-impedance resistor (2) which is operative between the line and the input (6) of the operational amplifier (7) during the through-connection of the respective line (1), and that the amplifier (7) is connected in such a way that its input (6), independently of the input current, is substantially at zero potential and the measuring potential (23) appearing at its output is proportional to the current flowing at its input (6).

3. Circuit arrangement according to claim 1 for monitoring the potential difference on pairs (30) of lines, characterized in that with each wire of the said pairs of lines there is associated a high-impedance resistor (2) which is operative between the respective wire and the input (33, 34) of one of the two operational amplifiers (36, 37) during the through-connection of a pair, and that the amplifiers (36, 37) are interconnected in such a way that their inputs (33, 34), independently of the input currents, are substantially at zero potential and the measuring potential appearing at a common output (23) is proportional to the difference between the currents flowing at their inputs (33, 34).

4. Circuit arrangement according to claim 3, characterized by an inverting amplifier (43, 44, 45) which produces a potential (46) inverse to the reference potential (24), by a first comparator (41) for comparing the said measuring potential (23) with the reference potential (24), and by a second comparator (42) for comparing the measuring potential (23) with the inverted reference potential (46), the outputs (47) of the two comparators being connected in parallel to the output of the test apparatus in such a way that the output signal (18) of the test apparatus depends solely upon the comparison of the absolute value of the potential difference with the threshold value.

5. Circuit arrangement according to claim 1, characterized by an OR-ELSE gate (15) having two inputs, to one input of which the output of the test apparatus (47) is connected and to the other input of which a control signal (48) is applied, with the aid of which the digital output signal of the test apparatus is optionally invertable.

## Revendications

1. Agencement de circuit destiné à être connecté à un central téléphonique pour superviser la variation des potentiels sur une pluralité de lignes (1), ou la variation des différences de potentiel sur une pluralité de paires (30) de lignes, quant au fait que chaque potentiel individuel ou différence de potentiel individuelle se situe au-dessus ou au-dessous d'une unique valeur de seuil déterminée, agencement dans lequel d'une part des valeurs binaires sont produites à l'aide d'au moins un comparateur (9; 41, 42) et un potentiel de référence fixe (24) en dépendance des potentiels supervisés, et d'autre part un multiplexeur (3, 5; 3, 32), entrant selon une séquence cyclique en relation avec les lignes individuelles (1; 30), est disposé sur la voie allant des lignes à une sortie (18) pour les dites valeurs binaires, caractérisé en ce que (ou les) comparateur(s) (9; 41, 42) est (sont) contenu(s) dans un unique dispositif central de contrôle (21) disposé entre le multiplexeur (3, 5; 3, 32) et la sortie (18), en ce que le dispositif de contrôle (21) comprend un amplificateur opérationnel (7; 36, 37) engendrant un potentiel de mesure (23) proportionnel au potentiel ou à la différence de potentiel de la ligne (1) ou de la paire de lignes (30) qui lui est connectée par le multiplexeur (3, 5; 3, 32), en ce que le multiplexeur (3;. 3, 32) est un multiplexeur analogique, et en ce que des moyens à circuit (10, 11, 12, 13, 14), digitalement ajustables en grands et petits pas, sont présents et engendrent le potentiel de référence (24) en tant qu'un potentiel se trouvant en une certaine relation fixement ajustée par rapport au potentiel d'alimentation (—), le potentiel de référence (24) étant, en adaptation à différents types de centraux téléphoniques, ajusté une fois de façon ferme avant d'être installé.

2. Agencement de circuit selon la revendication 1, caractérisé en ce que, à chaque des dites lignes (1), est associée une résistance à valeur ohmique élevée (2) qui est efficace entre la ligne et l'entrée (6) de l'amplificateur opérationel (7) lorsque cette ligne (1) se trouve mise en connexion, et en ce que l'implicateur (7) est connecté de façon telle que, indépendamment du courant d'entrée, son entrée (6) se trouve pratiquement au potentiel zéro et que le potentiel de mesure (23) apparaissant à sa sortie se trouve proportionnel au courant s'écoulant à son entrée (6).

3. Agencement de circuit selon la revendication 1, pour la supervision de la différence de potentiel sur des paires de lignes (30), caractérisé en ce que, à chaque conducteur de la dite paire de lignes, est associée une résistance de valeur ohmique élevée (2) qui est efficace entre le conducteur correspondant et l'entrée (33, 34) d'un des deux amplificateurs opérationel (36, 37), et en ce que les amplificateurs (36, 37) sont interconnectés d'une façon telle que, indépendamment des courants d'entrée, leurs entrées (33, 34) se trouvent pratiquement au potentiel zéro et que le potentiel de mesure apparaissant sur une sortie commune (22) se trouve proportionnel à la différence des courants s'écoulant à leurs entrées (33, 34).

4. Agencement de circuit selon la revendication 3, caractérisé par un amplificateur inverseur (43, 44, 45) qui engendre un potentiel (46) inverse du potentiel de référence (24), par un premier comparateur (41) pour comparer le dit potentiel de mesure (23) avec le dit potentiel de référence (24), et par un second comparateur (42) pour comparer le dit potentiel de mesure (23) avec le potentiel de référence inversé (46), les sorties (47) des deux comparateurs étant connectées en parallèle à la sortie du dispositif de contrôle d'une façon telle que le signal de sortie (18) d dispositif de contrôle dépende exclusivement de la comparaison de la valeur absolue de la différence de potentiel avec la valeur de seuil.

5. Agencement de circuit selon la revendication 1, caractérisé par une porte OU-EXCLUSIF (15) à deux entrées, à une entrée de laquelle est connectée la sortie du dispositif de contrôle (47) et à l'autre entrée de laquelle est connecté un signal de commande (48) à l'aide duquel le signal de sortie digital du dispositif de commande peut être inversé à volonté.

Fig. 1

Fig.2